# EUROPEAN PATENT APPLICATION

(11) **EP 3 413 322 A1**
(43) Date of publication of application: **12.12.2018**
(21) Application number: 17175096.1
(22) Date of filing: 08.06.2017
(51) Int. Cl.: H01F 27/38, H01F 27/42, H01F 29/14

(54) **ACTIVE INDUCTOR**

(71) Applicant: Goodrich Control Systems, Solihull West Midlands B90 4LA (GB)
(72) Inventor: Popek, Grzegorz, Birmingham B14 5QH (GB); Gietzold, Thomas, Stratford upon Avon CV37 0BQ (GB)
(74) Representative: Dehns

(57) **Abstract**

Disclosed herein is an inductor (11) comprising a primary winding (1). The inductor further comprises a secondary winding (3) wound around the same core (2) as the primary winding (1). The secondary winding (3) is connected to an excitation stage (4) that causes the secondary winding (3) to selectively generate flux at one or more frequencies in order to vary the magnetic behaviour of the inductor.

## Description

### TECHNICAL FIELD

The present disclosure relates generally to inductors.

### BACKGROUND

The development of traditionally passive electronic components in modern power electronics, such as inductors, is lagging behind the development of active devices like SiC and GaN semiconductors, such that in many applications the passive electronic components are still responsible for the majority of the weight and/or volume of the power electronic devices despite increased switching frequencies (e.g. the rate at which a DC voltage is switched on and off during a pulse width modulation process) generally allowing for physically smaller components to be used in switching regulators such as inverters or converters within switched-mode power supplies.

However, for many applications, particularly when these components are used for power electronics of aircrafts, or other such applications where it may generally be beneficial to reduce the size of the electronics, it may be desired to try to reduce the size of these components and/or to provide an increased performance for a given size.

### SUMMARY

From a first aspect of the disclosure, there is provided an inductor comprising:
a primary winding extending between first and second terminals for connecting the inductor into a circuit, the inductor presenting an inductance between the first and second terminals, wherein the primary winding is wound around a magnetic core;
the inductor further comprising a secondary winding wound around the magnetic core; and an excitation stage operatively connected to the secondary winding, wherein the excitation stage is configured to control the secondary winding to selectively generate magnetic flux at one or more frequencies or ranges of frequencies in order to vary the magnetic behaviour of the inductor.

The excitation stage may be configured to cause the secondary winding to generate magnetic flux to selectively oppose, attenuate or cancel flux generated by the primary winding at one or more frequencies or ranges of frequencies.

The excitation stage may be configured to cause the secondary winding to generate magnetic flux to selectively oppose, attenuate or cancel flux generated by the primary winding at frequencies less than a selected threshold frequency. For example, the selected threshold frequency may comprise a nominal switching frequency e.g. of a switched-mode power supply, or particularly the nominal switching frequency for a switching regulator, such as a converter or inverter, including the inductor. That is, the inductor may comprise a (or part of a) switching regulator or a switched-mode power supply, and the selected threshold frequency may be a nominal switching frequency of the switching regulator or switched-mode power supply. For instance, depending on the application, the excitation stage may be configured to cause the secondary winding to generate magnetic flux to selectively oppose, attenuate or cancel flux generated by the primary winding at frequencies less than about 2 kHz, or less than about 1 kHz, or less than about 500 Hz.

The excitation stage may be configured to cause the secondary winding to generate magnetic flux to selectively boost flux generated by the primary winding at one or more frequencies or ranges of frequencies.

The excitation stage may be configured to cause the secondary winding to selectively generate magnetic flux in order to keep the flux within the inductor substantially at or below a selected (e.g. desired) threshold flux value. For example, the secondary winding may be controlled to selectively generate magnetic flux so that the inductor tracks the maximum permeability of the core material.

The excitation stage may comprise an adjustable current source and one or more processing units or controllers, wherein the one or more processing units or controllers are configured to determine a required current for causing the secondary winding to generate a selected (e.g. desired) magnetic flux, and wherein the adjustable current source is arranged to provide the required current to the secondary winding so as to generate the selected (or desired) magnetic flux.

The one or more processing units or controllers may be configured to determine the required current based on a measurement or estimation of the flux within the inductor. For example, the measurement or estimation of the flux within the inductor may be performed by: (i) measuring a current between the first and second terminals; (ii) measuring a voltage across the first and second terminals; or (iii) measuring a voltage across the secondary winding. As another example, the flux within the inductor may additionally or alternatively be measured directly. The inductor may thus further comprise a sensor for directly measuring the flux within the inductor. The sensor may e.g. comprise a Hall effect sensor, or any other suitable sensor that is sensitive to magnetic field or flux.

The excitation stage may comprise a control loop for dynamically adjusting the flux generated in the secondary winding based on the flux within the inductor.

From a further aspect of the disclosure there is providing a method of using an inductor substantially as described herein, the method comprising selectively generating magnetic flux using the secondary winding to oppose, attenuate or cancel flux generated by the primary winding at one or more frequencies or ranges of frequencies so as to prevent or delay saturation of the core.

From a yet further aspect of the disclosure there is provided a method of using an inductor substantially as described herein, the method comprising selectively generating magnetic flux using the secondary winding to boost flux generated by the primary winding at one or more frequencies or ranges of frequencies of interest so as to increase the effective inductance as measured between the first and second terminals of the inductor at the one or more frequencies of ranges of frequencies of interest.

From a still further aspect of the disclosure there is provided a method of using an inductor substantially as described herein, the method comprising selectively generating magnetic flux using the secondary winding so as to control the flux within the inductor at or below a selected (e.g. desired) threshold flux value, for example, so that the inductor tracks the maximum permeability of the core material as the input current provided to the inductor varies.

### BRIEF DESCRIPTION OF THE DRAWINGS

Various arrangements and embodiments will now be described, by way of example only, and with reference to the accompanying drawings in which:
Fig. 1 shows an inductor according to an example of the present disclosure;
Fig. 2 shows schematically the components of an example of an excitation stage for use with an inductor of the type shown in Fig. 1; and
Fig. 3 shows an inductor of the type shown in Fig. 1 having an air gap.

### DETAILED DESCRIPTION

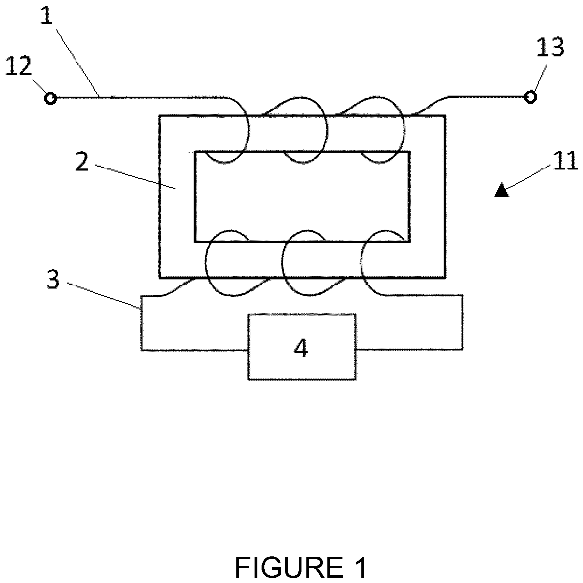

Fig. 1 shows a schematic of an inductor 11 according to an example of the present disclosure. The inductor 11 may generally be incorporated into an electrical or electronic circuit (not shown) such as an electronic power circuit of an aircraft. The inductor 11 thus comprises a primary winding 1 generally extending between a first (input) terminal 12 and a second (output) terminal 13 of the inductor 11 which are used to interface with other the components in the circuit. Thus, the inductor 11 may be connected into a circuit between the first terminal 12 and the second terminal 13. The inductor 11 presents to the circuit an inductance, L, between the first terminal 12 and the second terminals 13.

As is conventional, the primary winding 1 of the inductor 11 is wound around a core 2 of magnetic material. The magnetic core 2 may comprise a substantially rectangular core, as shown in Fig. 1. However, it will be appreciated that the magnetic core 2 may generally take various other suitable shapes. For instance, the magnetic core 2 may equally comprise a toroidal core, or a "C" or "E" type core. Similarly, the magnetic core 2 may be formed from a variety of suitable magnetic materials. Typical core materials are used for their properties as magnetic conductors and may be chosen for having a relatively high magnetic permeability. For example, the core 2 may comprise iron or ferrite.

When a current is supplied to an inductor 11, the inductor 11 generally acts to store energy in the form of a magnetic field. The energy storage capacity of a conventional inductor may generally be limited by the level of current that the core can withstand before reaching saturation. Initially the magnetic flux increases more or less linearly, or at least consistently, with current, but as the core material starts to become saturated, the magnetic flux no longer increases linearly with current, and eventually, at the saturation current, the magnetic flux cannot be increased any further. In order to increase the inductor current and avoid saturation, the size of the core may thus be increased. However, to ensure that the core is large enough to not saturate under the typical operating current for a particular application, it may be necessary to use relatively large and bulky cores. Thus, for conventional inductors, the size and weight of the inductor may typically be determined primarily by the size of the core required to prevent saturation.

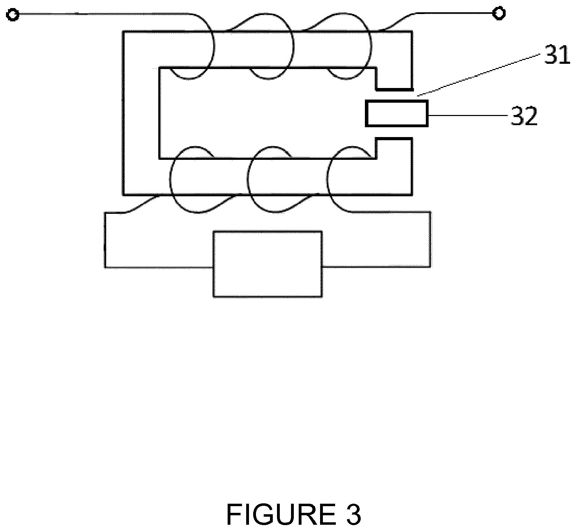

In various examples of inductors 11 according to the techniques presented herein, the core 2 may comprise an air gap 31 (e.g. as shown in Fig. 3) in order to reduce the effects of saturation by increasing the reluctance of the magnetic circuit in a known manner, thus allowing the inductor 11 to store more magnetic energy before saturation. Alternatively, or additionally, the core 2 may comprise one or more permanent magnets for biasing the inductor 11 and extending the saturation flux limit. However, these approaches by themselves may still not permit a more effective utilisation of the core material.

Accordingly, the inductors presented herein further comprise a secondary winding 3, also wound around the core 2, and connected to an excitation stage 4. As shown in Fig. 1, the secondary winding 3 may be separate from and not electrically connected to the primary winding 1. That is, the secondary winding 3 may be galvanically isolated from the primary winding 1. The secondary winding 3 may thus be connected to a separate power source to that which is connected as part of the circuit to the primary winding 1. However, it is also contemplated that the secondary winding 3 and/or the excitation stage 4 may be connected to the same power source that is connected to the primary winding 1, in which case the secondary winding 3 may not be electrically isolated from the primary winding 1.

The secondary winding 3 is controlled by the excitation stage 4 and is used to selectively generate flux in order to actively control (e.g. to substantially optimise) the magnetic behaviour of the inductor 11 depending on the desired application. That is, the inductors presented herein may be "active" inductors that may be controlled in order vary the magnetic behaviour of the inductor depending on the desired application. The active inductor may be controlled dynamically or selectively depending on the desired application and/or the current operating conditions or input current. In particular, the excitation stage 4 may control the secondary winding 3 to selectively generate flux that helps to extend the saturation flux limit of a given magnetic material, thereby increasing the energy storage capability of the inductor resulting in either a size reduction or an increased efficiency for a given size.

For many applications in modern control electronics (e.g. where the inductor is used in continuous current operation, or where the inductor is used as a switching regulator such as a converter or inverter) the input current provided to the first terminal 12 of the inductor 11 may comprise both AC and DC components. The control signals typically utilise relatively high frequency (e.g. 10 kHz or above) "ripple currents". However, the saturation of the core is generally dominated by the lower or zero (i.e. DC) frequency components of the input current, whereas the higher frequency flux typically has a lower associated current harmonics. Thus, according to the techniques presented herein, the excitation stage 4 may control the secondary winding 3 to selectively generate low frequency flux that opposes or cancels only the flux generated in the primary winding 1 by the lower frequency components of the input current. For instance, the secondary winding 3 may be controlled to selectively generate flux that opposes or cancels only the flux generated in the primary winding 1 by components of the input current having frequencies lower than the nominal switching frequency of a switched-mode power supply, or particularly the nominal switching frequency for a switching regulator such as a converter or inverter, including the inductor 11. Similarly, the excitation stage 4 may control the secondary winding 3 to selectively generate flux at one or more specific frequencies or ranges of frequencies. For instance, flux may be generated at various frequencies of flux e.g. so as to attenuate certain harmonics, or otherwise undesired components of flux. In various examples, the active inductor may therefore effectively act as a filter, and particularly as a filter with selective attenuation, to remove certain frequencies in primary winding current. Particularly, the active inductor may filter out certain low frequencies of flux in order to prevent or delay saturation of the core 2. Thus, in various examples, the low or zero frequency flux can be removed to de-saturate the core 2 and ensure that the core 2 sees only the higher frequency ripple currents in the primary winding 1.

As another example, the excitation stage 4 may additionally, or alternatively, control the secondary winding 3 to inject in phase flux at one or more frequencies, or ranges of frequencies, of interest so as to boost the response of the inductor 11 at those frequencies. That is, the active inductor may act to focus or boost the current and/or flux at various desired frequencies. For instance, it is contemplated the secondary winding 3 may be used to produce higher frequency flux in phase with the flux produced by the ripple currents in the primary winding 1. Thus, the flux in the core 2 corresponding to the frequencies of the ripple currents may be increased so that the voltages as measured across the first and second terminals 12,13 of the inductor 11 are higher (i.e. the effective inductance at higher frequencies is boosted, without requiring any additional turns or material in the primary winding 1). For example, depending on the application, flux may be generated using the secondary winding 3 to boost one or more, or all, frequencies in the range of about 10 kHz or above, or 20 kHz or above. For example, where the inductor 11 is used within a switching regulator or switched-mode power supply, the secondary winding 3 may be used to boost flux at one or more, or all, frequencies in a range that is greater than the nominal switching frequency of the switching regulator or switched-mode power supply.

As a further example, the secondary winding 3 may be used to control the total flux in the inductor 11. For example, the excitation stage 4 may dynamically alter, remove or limit the flux generated by the secondary winding 3 in order to keep the total flux in the inductor 11 (generated from both the primary winding 1 and the secondary winding 3) at or below a certain threshold or target value. For instance, in some examples, the flux generated by the secondary winding 3 may be controlled in order to allow the inductor 11 to track the maximum permeability (e.g. as determined from the slope of the B-H curve), in use, as the input current changes.

Thus, it will be appreciated that according to the techniques presented herein the excitation stage 4 may control the secondary winding 3 in various ways to selectively generate flux in order to better utilise the core material in order to allow for a reduction in size and/or an increased efficiency for a given size of core material.

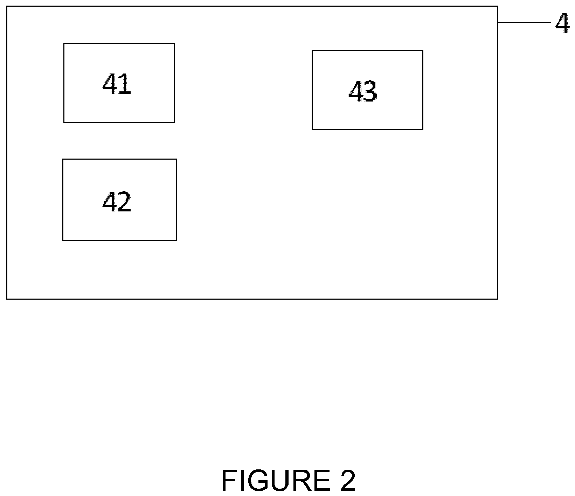

It will be appreciated that the excitation stage 4 generally acts to control the secondary winding 3 so as to selectively and/or dynamically control the frequencies of flux within the inductor 11. As shown in Fig. 2, the excitation stage 4 may thus generally comprise a power converter which acts as adjustable current source 41 for providing a current to the secondary winding 3 in order to generate the desired flux. The excitation stage 4 may further comprise suitable control circuitry and/or one or more processing units 42 for determining the desired flux and/or the required current to be provided to the secondary winding 3 to generate the desired flux. For example, the desired flux or current may be determined by the excitation stage 4 using a measurement or estimation of the current amount of flux within the inductor 11. However, it is also contemplated that the excitation stage 4 may comprise only a secondary power converter which acts as a current source, and that suitable control circuitry and/or processing means (not shown) may be provided e.g. in a further stage that is external to but in communication with the excitation stage 4. Once the desired flux and/or required current has been determined, either by the excitation stage 4 or by a further stage, the excitation stage 4 may provide one or more control signals or currents to the secondary winding 3. For instance, the excitation stage 4 may comprise a control or feedback loop 43 that monitors the flux within the inductor 11, and then generates suitable opposing or boosting flux using the secondary winding 3 to control or adjust the flux towards a desired target. The control or feedback loop 43 may thus receive as input a measurement or estimation of the flux within the inductor 11, and then provide a suitable output to the adjustable current source 41 in order to generate the appropriate flux. Thus, where it is desired to remove low frequency flux generated by the primary winding 1, in order to prevent saturation of the core 2 as described above, the excitation stage 4 may determine the current for the secondary winding 3 required to generate the appropriate opposing flux by first measuring or estimating the amount of low frequency flux within the inductor 11.

The flux within the inductor 11, or particularly the flux associated with the input current to the primary winding 1, may be determined by various suitable techniques. For example, the flux within the inductor 11 may be determined by monitoring the current in the primary winding, which would typically be measured anyway. As another example, the flux within the inductor 11 may be determined by measuring the voltage drop across the primary winding 1 and/or the secondary winding 3 of the inductor 11. Furthermore, the flux within the inductor 11 may be measured directly using a sensor. For example, the flux within the inductor 11 may be measured directly by providing a Hall effect sensor 32 (or indeed any other sensor that is suitably sensitive to magnetic flux or fields) within an air gap 31 of the core 2, as shown in Fig. 3. It will be appreciated that the sensor 32 need not be provided within an air gap 31 of the core 2, but may be provided in various other locations provided that the flux may suitably be measured. However the flux is determined, the excitation stage 4 may then use this determination to provide the required signal or current to cause the secondary winding 3 to generate the desired opposing and/or boosting flux.

It will be appreciated that the inductors presented herein may generally find application in various electrical or electronic control systems. As one example, the inductors presented herein may be used within an internal electronic control system of an aircraft or automobile. For instance, the inductors presented herein may be used as part of a motor drive electronic control system for an aircraft or automobile. Typically, the inductors may be used for DC grid applications having a ripple current requirement. However, the inductors presented herein may generally be used in any application where it is desired to reduce the weight or increase the efficiency of the passive components e.g. DC chokes in DC links.

In particular examples, the inductor may be used as or as part of a switching regulator, such as a converter or inverter. For instance, the inductor may be used as part of a switching regulator for use within a switched-mode power supply. As mentioned above, in this case, the inductor may be controlled to selectively remove or attenuate frequencies of flux below the nominal switching frequency of the switched-mode power supply. Accordingly, the present disclosure also relates to switching regulators (such as converters or inverters) comprising an inductor substantially of the type described hereinabove and/or switched-mode power supplies comprising a switching regulator and/or inductor substantially of the types described hereinabove.

Although the techniques presented herein have been described with reference to particular embodiments, it will be understood by those skilled in the art that various changes in form and detail may be made without departing from the scope of the invention as set forth in the accompanying claims.

## Claims

1. An inductor (11) comprising:
a primary winding (1) extending between a first terminal (12) and a second terminal (13) for connecting the inductor (11) into a circuit, the inductor (11) presenting an inductance (L) between said first and second terminals, wherein the primary winding (1) is wound around a magnetic core (2);
the inductor (11) further comprising a secondary winding (3) wound around said magnetic core (2); and an excitation stage (4) operatively connected to said secondary winding (3), wherein said excitation stage (4) is configured to control said secondary winding (3) to selectively generate magnetic flux at one or more frequencies or ranges of frequencies in order to vary the magnetic behaviour of the inductor (11).

2. An inductor (11) as claimed in claim 1, wherein said excitation stage (4) is configured to cause said secondary winding (3) to generate magnetic flux to selectively oppose, attenuate or cancel flux generated by said primary winding (1) at one or more frequencies or ranges of frequencies.

3. The inductor (11) of claim 2, wherein said excitation stage (4) is configured to cause said secondary winding (3) to generate magnetic flux to selectively oppose, attenuate or cancel flux generated by said primary winding (1) at frequencies less than a selected threshold frequency, optionally wherein said inductor comprises a or part of a switching regulator or a switched-mode power supply, and said selected threshold frequency is a nominal switching frequency of said switching regulator or switched-mode power supply.

4. An inductor (11) as claimed in any of claims 1, 2 or 3, wherein said excitation stage (4) is configured to cause said secondary winding (3) to generate magnetic flux to selectively boost flux generated by said primary winding (1) at one or more frequencies or ranges of frequencies.

5. An inductor (11) as claimed in any preceding claim, wherein said excitation stage (4) is configured to cause said secondary winding (3) to selectively generate magnetic flux in order to keep the flux within said inductor (11) substantially at or below a selected threshold flux value.

6. The inductor (11) of claim 5, wherein the secondary winding (3) is controlled to selectively generate magnetic flux so that said inductor (11) tracks the maximum permeability of the core (2) material.

7. An inductor (11) as claimed in any preceding claim, wherein said excitation stage (4) comprises an adjustable current source (41) and one or more processing units or controllers (42), wherein said one or more processing units or controllers (42) are configured to determine a required current for causing said secondary winding (3) to generate a selected magnetic flux, and wherein said adjustable current source (41) is arranged to provide said required current to said secondary winding (3) so as to generate said selected magnetic flux.

8. The inductor (11) of claim 7, wherein said one or more processing units or controllers (42) are configured to determine the required current based on a measurement or estimation of the flux within the inductor (11).

9. The inductor (11) of claim 8, wherein said measurement or estimation of the flux within the inductor (11) is performed by: (i) measuring a current between said first and second terminals; (ii) measuring a voltage across said first and second terminals; or (iii) measuring a voltage across said secondary winding (3).

10. The inductor (11) of claim 8 or 9, wherein the flux within the inductor (11) is measured directly.

11. The inductor (11) of any preceding claim, further comprising a sensor (32) for directly measuring the flux within the inductor (11).

12. The inductor (11) of any preceding claim, wherein said excitation stage (4) comprises a control loop (43) for dynamically adjusting the flux generated in said secondary winding (3) based on the flux within the inductor (11).

13. A method of using the inductor (11) of any preceding claim comprising selectively generating magnetic flux using said secondary winding (3) to oppose, attenuate or cancel flux generated by said primary winding (1) at one or more frequencies or ranges of frequencies so as to prevent or delay saturation of the core (2).

14. A method of using the inductor (11) of any of claims 1 to 12 comprising selectively generating magnetic flux using said secondary winding (3) to boost flux generated by said primary winding (1) at one or more frequencies or ranges of frequencies of interest so as to increase the effective inductance (L) as measured between the first and second terminals of the inductor (11) at said one or more frequencies of ranges of frequencies of interest.

15. A method of using the inductor (11) of any of claims 1 to 12 comprising selectively generating magnetic flux using said secondary winding (3) so as to control the flux within said inductor (11) at or below a selected threshold flux value, for example, so that said inductor (11) tracks the maximum permeability of the core (2) material as the input current provided to the inductor (11) varies.
